# EUROPÄISCHE PATENTANMELDUNG

(11) **EP 3 351 910 A2**
(43) Veröffentlichungstag der Anmeldung: **25.07.2018**
(21) Anmeldenummer: 18152501.5
(22) Anmeldetag: 29.10.2008
(51) Int. Cl.: G01F 23/284, G01S 13/06, H01L 23/02, H01L 23/16, G01S 7/03, G01S 13/88, H01L 23/055, H01L 23/552, H01L 23/00, H01L 23/66

(54) **HOCHFREQUENZMODUL ZUR FÜLLSTANDMESSUNG IM W-BAND**

(62) Teilanmeldung aus: 08167856.7
(71) Anmelder: VEGA Grieshaber KG, 77709 Wolfach (DE)
(72) Erfinder: SCHULTHEISS, Daniel, 78132 Hornberg (DE); FISCHER, Michael, 72275 Alpirsbach (DE)
(74) Vertreter: Maiwald Patent- und Rechtsanwaltsgesellschaft mbH

(57) **Zusammenfassung**

Gemäß einem Ausführungsbeispiel der Erfindung ist ein Hochfrequenzmodul zur Füllstandmessung und zur Verwendung bei Frequenzen von über 75 GHz angegeben, welches einen Mikrowellenhalbleiter, eine Leiterplatte und ein auf die Leiterplatte aufgeklebtes Gehäuse aufweist. Zur Reduzierung der benötigten Leistung erfolgt der Betrieb des Mikrowellenhalbleiters getaktet.

## Beschreibung

### Gebiet der Erfindung

Die Erfindung betrifft die Füllstandmessung. Insbesondere betrifft die Erfindung ein Hochfrequenzmodul zur Füllstandmessung bei Frequenzen von über 75 GHz, ein Füllstandradar mit einem Hochfrequenzmodul, sowie ein Verfahren zum Betrieb eines Füllstandsensors mit einem Hochfrequenzmodul.

### Technologischer Hintergrund

Die Verwendung hoher Frequenzen bei der Füllstandmessung bietet vielerlei Vorteile. Beispielsweise können hierdurch die Bauteile der Sensoren verkleinert werden.

Bei der Füllstandmessung im Hochfrequenzbereich werden drei Frequenzbänder voneinander unterschieden. Zum einen das sog. C-Band, das zwischen 4 und 8 GHz liegt. Weiterhin gibt es das K-Band, das zwischen 18 und 27 GHz liegt und das sog. W-Band, das etwa zwischen 75 und 110 GHz liegt.

Die hohen Frequenzen des W-Bandes erfordern im Vergleich zu den anderen Frequenzbändern besondere Aufbautechniken des HF-Moduls, die bei Frequenzen im C- und K-Band nicht notwendig sind.

Während in den Elektronikmodulen von Füllstandradargeräten (sog. Radar-Frontends), die im C- oder im K-Band arbeiten, ausschließlich gehäuste Hochfrequenzbauteile (HF-Bauteile) eingesetzt werden, werden im W-Band bisher generell nur ungehäuste Bauteile verwendet. Der Grund dafür liegt darin, dass bei den hohen Frequenzen im W-Band die parasitären Effekte eines Bauteilgehäuses die Funktion der Hochfrequenzbauteile und auch die Funktionen der monolithischen integrierten Mikrowellenschaltkreise (MMIC, Monolithic Microwave Integrated Circuit) stark beeinträchtigen könnten.

### Zusammenfassung der Erfindung

Es ist eine Aufgabe der Erfindung, ein verbessertes Hochfrequenzmodul zur Füllstandmessung im W-Band anzugeben.

Es sind ein Hochfrequenzmodul zur Füllstandmessung, ein Füllstandradar und ein Verfahren zum Betrieb eines Füllstandsensors gemäß den Merkmalen der unabhängigen Ansprüche angegeben. Weiterbildungen der Erfindung ergeben sich aus den Unteransprüchen.

Die beschriebenen Ausführungsbeispiele betreffen gleichermaßen das Hochfrequenzmodul, das Füllstandradar und das Verfahren. In anderen Worten lassen sich die im Folgenden im Hinblick auf das Hochfrequenzmodul genannten Merkmale auch in dem Verfahren und dem Füllstandradar implementieren, und umgekehrt.

Gemäß einem Ausführungsbeispiel der Erfindung ist ein Hochfrequenzmodul zur Füllstandmessung und zur Verwendung bei Frequenzen von über 75 GHz, insbesondere zur Verwendung bei Frequenzen im W-Band, angegeben. Das Hochfrequenzmodul weist einen Chip in Form eines Mikrowellenhalbleiters (auch Mikrowellenschaltkreis, Mikrowellen-IC, MMIC oder Hochfrequenzbauteil genannt) und eine Leiterplatte sowie ein Gehäuse für das Hochfrequenzmodul und insbesondere für den Mikrowellenhalbleiter auf, das auf die Leiterplatte leitfähig aufgeklebt ist. Das Gehäuse dient nicht nur für den Mikrowellenhalbleiter sondern für die gesamte HF-Schaltung.
Durch das Aufkleben und/oder Klemmen des Hochfrequenzgehäuses bzw. HF-Deckels direkt auf bzw. an die Leiterplatte wird eine aufwändigere Montage des Mikrowellenhalbleiters in ein Fräsgehäuse vermieden. Anstelle einzelner Schaltungsteile auf Keramik kann eine Gesamtleiterplatte als Verbundleiterplatte (z. B. FR4/Teflon) oder Mehrlagenplatine (Multilayer) verwendet werden.

Eine Verbundleiterplatte ist hierbei als ein Sonderfall der Multilayerleiterplatte zu sehen. Die Multilayerleiterplatte besteht im Allgemeinen aus mehreren Lagen des gleichen Materials (meist FR4). Bei der Verbundleiterplatte besteht mindestens eine Lage aus einem anderen Material z.B. aus Teflon oder einer Teflon-Keramik-Mischung.

Zum Aufkleben des Gehäuses auf die Leiterplatte wird beispielsweise leitfähiges Silikon verwendet. Rollnaht- oder Laserschweißungen zum Abdichten des Gehäuses sind nicht notwendig, da das Gehäuse nicht notwendiger weise luftdicht ist. Eine Edelgasfüllung des Gehäuses ist nicht notwendig. Somit kann das Hochfrequenzmodul kostengünstig, vereinfacht und mit verringertem Aufwand gefertigt werden.

Gemäß einem weiteren Ausführungsbeispiel der Erfindung ist das Gehäuse in einem Zinkdruckgussverfahren oder einem metallisierten Kunststoff hergestellt. Hierdurch können Herstellungskosten verringert werden.

Da das Gehäuse nicht luftdicht sein muss, ist eine Kontaktierung des Mikrowellenhalbleiters bzw. der Leitungen zur Steuerung bzw. Versorgung des HF-Moduls vom Inneren des Gehäuses nach außen über übliche SMD-Stecker möglich, anstelle von hermetisch dichten Glasdurchführungen.

Die Signalleitungen (Mikrowellensignale) werden durch eine Hohlleitereinkopplung in der Leiterplatte nach außen geführt. Alle anderen Leitungen zur Steuerung bzw. Versorgung des HF-Moduls werden über einen Stecker (in diesem Fall als SMD-Version) übertragen. Dieser sitzt beispielsweise auf der Rückseite der Leiterplatte, also nicht unter dem HF-Gehäuse. Das HF-Gehäuse selbst wird luftdicht auf die Leiterplatte aufgeklebt. Glasfenster bzw. -durchführungen, die bei dem Stand der Technik für die Hohlleiterauskopplung oder Steuer- und Versorgungsleitungen notwendig sind, werden demnach nicht benötigt.

Auch ist kein Vergießen des Mikrowellenhalbleiters notwendig.

Gemäß einem weiteren Ausführungsbeispiel der Erfindung weist das Gehäuse einen oder mehrere integrierte Trennstege zur Schirmung von elektromagnetischer Strahlung auf, der ebenfalls metallisch ausgeführt ist.

Beispielsweise sind der Trennsteg und das Gehäuse einstückig ausgeführt. Auch kann der Trennsteg an das Gehäuse angeklebt oder anderweitig dort befestigt sein.

Gemäß einem weiteren Ausführungsbeispiel der Erfindung weist das Gehäuse (ggf. zusätzlich zu dem metallischen integrierten Trennsteg) einen oder mehrere

Trennstege zur Schirmung von elektromagnetischer Strahlung auf, der aus Dämpfungsmaterial ausgeführt ist bzw. Dämpfungsmaterial aufweist.

Gemäß einem weiteren Ausführungsbeispiel der Erfindung ist das Hochfrequenzmodul zur Spannungsversorgung des Mikrowellenhalbleiters in einem getakteten Betrieb ausgeführt.

Auf diese Weise kann der Energieverbrauch des Mikrowellenhalbleiters und damit der Wärmeübertrag des Mikrowellenhalbleiters an die Umgebung herabgesetzt werden.

Es ist zu beachten, dass für dieses und die unteren Ausführungsbeispiele das beschriebene Gehäuse nicht notwendig ist. Der Mikrowellenhalbleiter kann auch ohne Gehäuse verwendet werden, falls ein Schutz durch das Gehäuse nicht erforderlich ist.

Gemäß einem weiteren Ausführungsbeispiel der Erfindung ist das Hochfrequenzmodul so ausgeführt, dass bei dem getakteten Betrieb bei einem Anschaltvorgang des Mikrowellenhalbleiters zuerst eine negative Versorgungsspannung und dann eine positive Versorgungsspannung an den Mikrowellenhalbleiter angelegt wird. Bei einem Abschaltvorgang des Mikrowellenhalbleiters wird zuerst die positive Versorgungsspannung und dann die negative Versorgungsspannung abgeschaltet.

Gemäß einem weiteren Ausführungsbeispiel der Erfindung ist der Mikrowellenhalbleiter auf der Leiterplatte platziert.

Beispielsweise ist der Mikrowellenhalbleiter direkt auf die Leiterplatte aufgeklebt.

Gemäß einem weiteren Ausführungsbeispiel der Erfindung weist das Hochfrequenzmodul eine Metallisierung auf, die zwischen dem Mikrowellenhalbleiter und der Leiterplatte angeordnet ist. In diesem Fall ist also der Mikrowellenhalbleiter nicht direkt auf der Leiterplatte platziert, sondern auf der Metallisierung, die sich auf der Leiterplatte befindet.

Gemäß einem weiteren Ausführungsbeispiel der Erfindung ist eine Signalleitung auf der Leiterplatte vorgesehen, die mit dem Mikrowellenhalbleiter verbunden ist. Über diese Signalleitung ist der Mikrowellenhalbleiter mit dem Gehäuseäußeren, also der Umgebung des Gehäuses verbunden.

Gemäß einem weiteren Ausführungsbeispiel der Erfindung ist die Leiterplatte als Verbundleiterplatte mit mehreren Lagen ausgeführt.

Gemäß einem weiteren Ausführungsbeispiel der Erfindung ist das Hochfrequenzmodul zur Verwendung für einen Radarsensor zur Füllstandmessung ausgeführt. Insbesondere ist das Hochfrequenzmodul zum Pulsradarbetrieb ausgeführt.

Gemäß einem weiteren Ausführungsbeispiel der Erfindung ist ein Füllstandradar mit einem oben beschriebenen Hochfrequenzmodul angegeben.

Gemäß einem weiteren Ausführungsbeispiel der Erfindung ist ein Verfahren zum Betrieb eines Füllstandsensors mit einem oben beschrieben Hochfrequenzmodul angegeben, bei dem der Mikrowellenhalbleiter des Hochfrequenzmoduls mit Spannung in einem getakteten Betrieb versorgt wird.

Gemäß einem weiteren Ausführungsbeispiel der Erfindung weist das Verfahren zur Durchführung des getakteten Betriebs in jedem Zyklus des getakteten Betriebs einen Vorgang zum Anlegen einer Versorgungsspannung und einen Vorgang zum Abschalten der Versorgungsspannung auf. Beim Anlegen erfolgt zuerst das Anlegen einer negativen Versorgungsspannung und dann das Anlegen einer positiven Versorgungsspannung an den Mikrowellenhalbleiter zum Anschalten des Mikrowellenhalbleiters in einem Zyklus des getakteten Betriebs. Beim Abschalten erfolgt zuerst ein Abschalten der positiven Versorgungsspannung und dann der negative Versorgungsspannung zum Abschalten des Mikrowellenhalbleiters in dem Zyklus des getakteten Betriebs.

Im Folgenden werden mit Verweis auf die Figuren Ausführungsbeispiele der Erfindung beschrieben.

### Kurze Beschreibung der Figuren

Fig. 1 zeigt eine schematische Querschnittdarstellung eines Hochfrequenzmoduls.
Fig. 2 zeigt eine schematische Querschnittdarstellung eines weiteren Hochfrequenzmoduls.
Fig. 3 zeigt eine Querschnittdarstellung eines Hochfrequenzmoduls gemäß einem Ausführungsbeispiel der Erfindung.
Fig. 4 zeigt ein Diagramm einer zeitlichen Schaltung der Versorgungsspannungen gemäß einem Ausführungsbeispiel der Erfindung.
Fig. 5 zeigt ein Blockschaltbild eines Hochfrequenzmoduls gemäß einem Ausführungsbeispiel der Erfindung.
Fig. 6 zeigt eine Querschnittdarstellung eines weiteren Hochfrequenzmoduls.
Fig. 7 zeigt eine Querschnittdarstellung eines Hochfrequenzmoduls gemäß einem weiteren Ausführungsbeispiel der Erfindung.
Fig. 8 zeigt ein Füllstandradar gemäß einem Ausführungsbeispiel der Erfindung.
Fig. 9 zeigt ein Flussdiagramm eines Verfahrens gemäß einem Ausführungsbeispiel der Erfindung.

### Detaillierte Beschreibung von Ausführungsbeispielen

Die Darstellungen in den Figuren sind schematisch und nicht maßstäblich.

In der folgenden Figurenbeschreibung werden für die gleichen oder ähnlichen Elemente die gleichen Bezugsziffern verwendet.

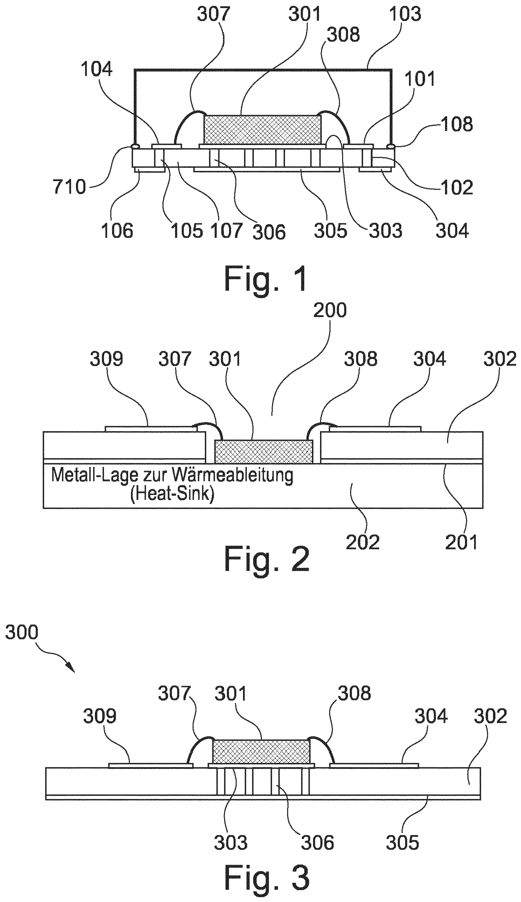

Fig. 1 zeigt eine Querschnittdarstellung eines Hochfrequenzmoduls, welches einen Mikrowellenhalbleiter (Chip) 301 aufweist, der auf eine Trägerplatte 107 (beispielsweise aus Keramik) aufgesetzt ist. Zwischen der Trägerplatte 107 und dem Chip 301 befindet sich eine Metallschicht 303.

Der Chip 301 ist über die Bonddrähte 307, 308 mit den weiterführenden Signalleitungen 104 bzw. 101 verbunden. Die Signalleitungen 101, 104 werden über entsprechende Durchkontaktierungen 102, 105 durch die Trägerplatte 107 hindurchgeführt und laufen dann an der Unterseite der Trägerplatte weiter (siehe Bezugszeichen 304, 106).

Weiterhin sind Durchkontaktierungen 306 unter dem Chip 301 vorgesehen, welche mit der metallischen Masseverbindung 305 auf der Unterseite der Trägerplatte verbunden sind. Diese Durchkontaktierungen dienen der Wärmeabführung.

Die Metallkontakte 304, 106 dienen zum Auflöten auf eine Leiterplatte (nicht gezeigt).

Weiterhin ist ein Gehäuse 103 vorgesehen, das hermetisch dicht mit der Trägerplatte 107 verklebt ist. Zur Verklebung dient die Klebeverbindung 710, 108.

Die Masseverbindung von der Leiterplatte zum Chip wird mit mehreren Durchkontaktierungen durch die Trägerplatte sichergestellt. Ebenso wird die Signalleitung mit Durchkontaktierungen nach außen geführt. Die Montage des Bauteils erfolgt schließlich durch Auflöten auf die Leiterplatte.

Diese Gehäuse- und Verbindungstechnik kann allerdings bei Frequenzen des W-Bandes nicht mehr angewendet werden. Das Bauteilgehäuse selbst, sowie die Durchführung der Signalleitung durch die Trägerplatte, würde zu sehr starken parasitären Effekten, wie z. B. Dämpfung und Fehlanpassung, führen. Im W-Band wird deshalb der ungehäuste Chip durch kurze Bonddrähte direkt mit der Signalleitung auf der Leiterplatte verbunden (siehe Fig. 2).

Fig. 2 zeigt eine Schnittdarstellung eines Hochfrequenzmoduls beispielsweise zur Verwendung im W-Band. Der Mikrowellenhalbleiter oder Chip 301 ist in einer Aussparung 200 in der Leiterplatte 302 platziert. Der Chip 301 ist über die Bonddrähte 307, 308 mit den entsprechenden Signalleitungen 309, 304 verbunden. Bei der Leiterplatte 302 handelt es sich um eine HF-Leiterplatte.

Weiterhin ist eine Metallisierung 201 auf der Unterseite der Leiterplatte vorgesehen, z. B. aus Kupfer (Masselage).

Die HF-Leiterplatte ist mit ihrer metallisierten Unterseite auf eine Metall-Lage zur Wärmeableitung 202 aufgesetzt, die also als Wärmesenke (Heat-Sink) dient.

In anderen Worten ist also der Chip 301 in einer Tasche (sog. Cavity) platziert, die z.B. aus der Leiterplatte ausgefräst ist.

Die Mikrowellenhalbleiter für das W-Band sind beispielsweise aus dem Halbleitermaterial Galliumarsenid (GaAs) hergestellt, da sich GaAs durch die hohe erreichbare Grenzfrequenz hervorragend für die Anwendung im Millimeterwellenbereich eignet. Hochfrequenzbauteile aus GaAs haben jedoch den Nachteil einer erhöhten Leistungsaufnahme und Verlustleistungsabgabe im Vergleich zu anderen Halbleiterwerkstoffen, wie z. B. Silizium. Selbst wenn kein Eingangssignal anliegt, nehmen die Chips Leistung auf und produzieren Verlustleistungen in Form von Wärme, die abgeleitet werden muss. Deshalb werden die Chips üblicherweise direkt auf einer Metall-Lage (Heat-Sink) aufgeklebt, die einerseits eine gute elektrische Masseverbindung auf die Unterseite des Chips gewährleistet und andererseits zur Wärmeableitung dient. Diese Aufbautechnik ist jedoch sehr teuer im Vergleich zu konventionellen SMD-Montagetechniken, wie sie z. B. im K-Band-Modul von Füllstandradarsensoren zum Einsatz kommen.

Entweder müssen also aufwändige Taschen in die Leiterplatte gefräst werden oder die Schaltung wird aus mehreren kleineren Leiterplatten, die in ein Metallgehäuse eingeklebt werden, zusammengesetzt, zwischen welchen die Chips platziert sind.

Fig. 3 zeigt ein Hochfrequenzmodul 300 ohne Wärmesenke zur Verwendung im W-Band. Hierbei ist der Chip 301 auf eine Metallisierung 303 auf der Leiterplatte 302 aufgesetzt. Über die Bonddrähte 307, 308 ist der Chip an die Signalleitungen 309, 304 angeschlossen. Die Signalleitungen 309, 304 befinden sich auf der selben Seite der Leiterplatte 302, wie auch der Chip 301. Durchkontaktierungen für die Signalleitungen sind nicht erforderlich.

Bei der Leiterplatte 302 handelt es sich beispielsweise um eine Multilayer-Leiterplatte.

Auf der Rückseite der Leiterplatte 302 befindet sich eine Metallisierung, beispielsweise in Form einer Kupferschicht als Masselage 305. Zur Masseverbindung des Chips sind Durchkontaktierungen 306 unter dem Chip vorgesehen.

Das Pulsradarverfahren, welches in Füllstandsensoren verwendet werden kann, hat den Vorteil, dass die Halbleiterbauelemente, welche den Sende- bzw. Empfangspuls verarbeiten, nur zu den Zeitpunkten angeschaltet sein müssen, zu denen ein Radarpuls anliegt. Zu allen anderen Zeiten kann die Versorgungsspannung des Mikrowellenhalbleiters abgeschaltet sein.

Durch diese Maßnahme kann die mittlere Leistungsaufnahme und dadurch auch die mittlere Verlustleistung der Chips deutlich reduziert werden. Eine Reduzierung der mittleren Leistungsaufnahme des Radarmoduls ist im Hinblick auf die Zweileiterfähigkeit, also der Versorgung des Sensors mit 4...20mA Strom, wünschenswert.

Die produzierte Wärmemenge, die über die Wärmesenke abgeführt werden muss, nimmt bei einer getakteten Versorgung ebenfalls ab. Ab einem bestimmten Verhältnis von Einschaltdauer zu Periodendauer (Puls-Pausen-Verhältnis oder Duty-Cycle) des Pulsradars kann bei einem getakteten Betrieb der HF-Halbleiter gänzlich auf die Wärmesenke verzichtet werden. Das Verhältnis hängt beispielsweise von der Wärmeleitfähigkeit der Leiterplatte und des verwendeten Klebers, von der elektrisch aufgenommenen Leistung, von dem Wirkungsgrad des Halbleiters sowie von der Chipfläche selbst ab.

Durch den Wegfall der Wärmesenke kann der Leiterplattenaufbau erheblich vereinfacht und kostengünstiger realisiert werden. Der Mikrowellenhalbleiter wird direkt auf die HF-Leiterplatte aufgeklebt (sog. Chip-On-Board-Montage).

Durchkontaktierungen unter dem Chip sorgen für eine gute elektrische Masseverbindung von der Masselage der HF-Leiterplatte zur Metallfläche unter dem Chip. Insbesondere sind auch keine Aussparungen bzw. Taschen in der HF-Leiterplatte erforderlich.

Bei der Chip-On-Board-Technik werden die Verbindungen von der Signalleitung auf der Leiterplatte auf den Chip ebenfalls mit kurzen Bonddrähten 307, 308 realisiert. Durch diese Aufbautechnik verändern sich die HF-Eigenschaften des Mikrowellenhalbleiters nicht signifikant nachteilig.

Im Folgenden wird die getaktete Spannungsversorgung des Mikrowellenhalbleiters am Beispiel des W-Band Vervielfacher-Chips CHU3377 der Fa. UMS detailliert beschrieben. Es handelt sich hierbei um einen Galliumarsenid-Chip, welcher ein Eingangssignal im Frequenzbereich von 12,67 GHz bis 12,83 GHz auf die Frequenz 76 GHz bis 77 GHz vervielfacht. Gleichzeitig wird das Ausgangssignal im W-Band mit diesem Baustein noch verstärkt.

An dieser Stelle sei zu bemerken, dass das erfindungsgemäße Hochfrequenzmodul sowohl für Frequenzen über 75 GHz, beispielsweise für Frequenzen im W-Band, und insbesondere für Frequenzen von 79 GHz ausgeführt sein kann. Ebenso kann das Hochfrequenzmodul aber auch für niedrigere Frequenzen, beispielsweise für Frequenzen von etwa 26 GHz, ausgeführt sein.

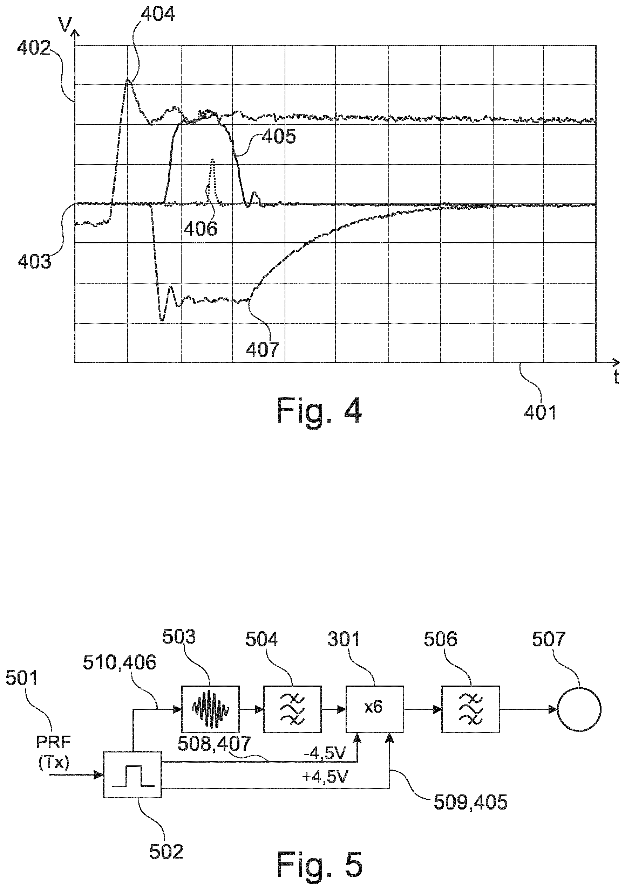

Fig. 4 zeigt den zeitlichen Verlauf der Versorgungsspannungen bei dem W-Band Vervielfacher MMIC CHU3377 bei einem getakteten Betrieb gemäß einem Ausführungsbeispiel der Erfindung. Die horizontale Achse 401 zeigt den zeitlichen Verlauf und weist die Einheit 10 ns/div auf, reicht also von 0 Nanosekunden bis 100 Nanosekunden.

Die vertikale Achse 402 zeigt die Spannung in Einheiten von 2 V/div, reicht also von -8 V bis +8 V.

Das Bezugszeichen 403 zeigt den Spannungsnullpunkt. Die Kurve 404 zeigt das Taktsignal (PRF), die Kurve 405 die positive Spannungsversorgung, die Kurve 407 die negative Spannungsversorgung und die Kurve 406 das Ansteuersignal für den Pulsgenerator.

Wie zu erkennen, wird die positive Spannungsversorgung nach der negativen Spannungsversorgung angeschaltet und vor der negativen Spannungsversorgung abgeschaltet.

Der Vervielfacher benötigt zwei Gleichspannungen zur Versorgung. Eine Spannung liegt im Bereich von +4,5 V, die andere Spannung im Bereich von -4,5 V. Durch das Anlegen der beiden Versorgungsspannungen werden alle Transistoren auf dem Chip in ihren Arbeitspunkt gebracht (sog. On-Chip Self Biasing). Hierbei ist zu beachten, dass die negative Versorgungsspannung unbedingt vor der positiven Versorgungsspannung angelegt werden muss. Andernfalls kann der Chip durch eine zu große Stromaufnahme zerstört werden. Beim Abschalten muss entsprechend zuerst die positive Spannung weggenommen werden und danach erst die negative. Im Fall der Fig. 4 ist die negative Versorgungsspannung ca. 30 Nanosekunden angeschaltet. Die positive Versorgung kommt ca. 2 bis 3 Nanosekunden später und liegt insgesamt 10 Nanosekunden an.

Die Leistungsaufnahme des Chips beträgt im sog. CW-Betrieb (Continuous Wave (Dauerstrichsignal)) ca. 900 mW auf der positiven und ca. 45 mW auf der negativen Versorgungsspannung. Durch den getakteten Betrieb kann die mittlere Leistungsaufnahme auf der positiven Versorgung auf ca. 50 mW und auf der negativen Versorgung auf ca. 6 mW reduziert werden.

Fig. 5 zeigt ein Blockschaltbild eines W-Band Sendezweigs mit einem Pulsgenerator 503 und einem Vervielfacher 301 mit getakteter Spannungsversorgung gemäß einem Ausführungsbeispiel der Erfindung. Das PRF (Tx) Signal 501 wird über die Steuereinheit 502 getaktet und zeitlich gesteuert. Insbesondere wird über die Leitung 510 ein Ansteuerungssignal 406 (siehe Fig. 4) an den Pulsgenerator 503 abgegeben. Das vom Pulsgenerator 503 erzeugte Signal durchläuft dann einen Bandpassfilter 504 und wird dann an den Vervielfacher 301 weitergeleitet. Ebenso erzeugt die Steuereinheit 502 die negative Versorgungsspannung und die positive Versorgungsspannung, die über die Leitungen 508 bzw. 509 an den Vervielfacher 301 übertragen werden. Das im Vervielfacher 301 erzeugte Signal wird dann an einen Bandpassfilter 506 weitergegeben, woraufhin es beispielsweise in einem Rundhohlleiter 507 eingekoppelt wird.

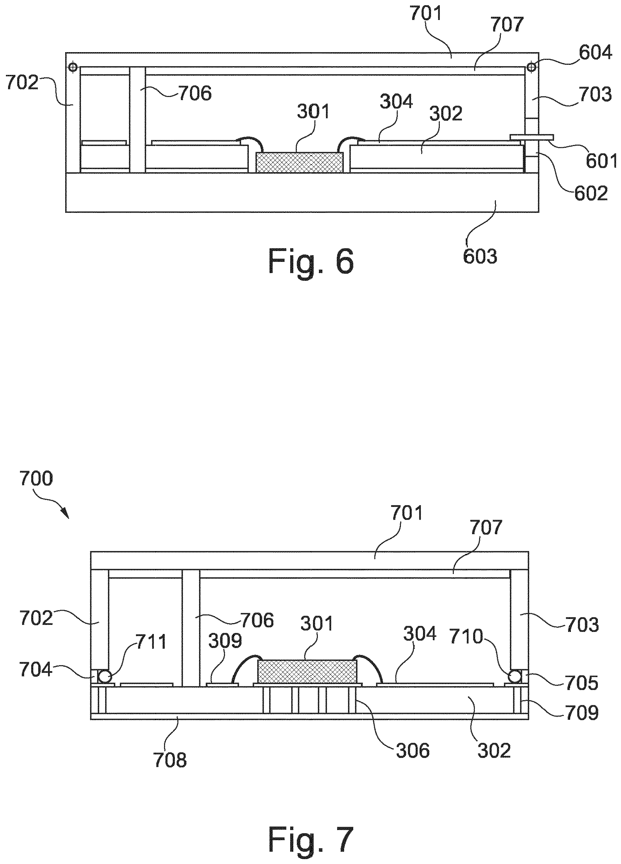

Fig. 6 zeigt ein Hochfrequenzmodul mit einem Gehäuse. Das Gehäuse weist ein Oberteil 701 sowie rechte und linke Seitenteile 703, 702 auf, die an das Oberteil 701 über die Schweißverbindungen 604 angeschweißt sind. Innerhalb des Gehäuses ist eine Edelgasfüllung vorgesehen. Das Gehäuse ist luftdicht. Die Signalleitung 304 wird über eine eingelötete Glasdurchführung 601, 602 aus dem Gehäuse herausgeführt.

Auch die Unterseite 603 ist Teil des Metallgehäuses. Somit ist die gesamte Leiterplatte mit dem in der Aussparung liegenden Chip 301 im luftdichten Gehäuse angeordnet. Weiterhin können Trennstege 706 zur internen Schirmung vorgesehen sein, sowie ein Dämpfungsmaterial 707 an der oberen Innenseite des Gehäuses.

Die Leiterplatte des HF-Moduls ist zur Schirmung und zum Schutz vor äußeren Einflüssen in das Gehäuse eingebaut. Der Chip 301, der sich z. B. in einer Tasche der Leiterplatte befindet, wird in der Leiterplatte direkt auf den metallischen Gehäuseboden 603 aufgeklebt. Der metallische Gehäuseboden dient gleichzeitig als Wärmesenke. Der Gehäusedeckel 701 ist durch eine Rollnahtschweißung oder Laserschweißung hermetisch dicht verschlossen. Zum Korrosionsschutz liegt innerhalb des Gehäuses eine Edelgasfüllung vor. Elektrische Verbindungen nach außen sind nur über eingelötete Glasdurchführungen möglich, welche aufwändig und somit verhältnismäßig teuer sind. Als Gehäusewerkstoff können Legierungen verwendet werden, welche die selben Wärmeausdehnungsverhalten aufweisen, wie die eingelöteten Glasdurchführungen. Meist werden somit Kovar- oder Invar-Legierungen als Gehäusewerkstoff verwendet.

Die Trennstege 706 im Inneren des Gehäuses dienen zur Schirmung verschiedener Schaltungsteile gegeneinander. Das eingeklebte Dämpfungsmaterial 707 am Gehäusedeckel dient zur Unterdrückung von Gehäuseresonanzen. Ein solches Gehäuse ist relativ komplex, erfordert den Einsatz besonderer Materialien, Bauteilen und Technologien und ist deshalb nicht kostengünstig herzustellen.

Fig. 7 zeigt ein Hochfrequenzmodul mit einem Gehäuse gemäß einem Ausführungsbeispiel der Erfindung.

Der Mikrowellenhalbleiter 301 verfügt über eine Passivierung, die ihn vor Umwelteinflüssen schützt. Diese Passivierung bietet in vielen Anwendungsfällen ausreichenden Schutz. Auf eine hermetische Dichtheit des Gehäuses und eine Edelgasfüllung wird verzichtet. Weiterhin wird auf die Wärmesenke verzichtet, so dass der Gehäuseaufbau wesentlich vereinfacht und damit auch kostengünstiger realisiert ist.

Insbesondere ist der Metalldeckel 701 mit den Seitenwänden 702, 703, 704, 705 direkt auf die Leiterplatte 302 mit Hilfe eines leitfähigen Klebstoffs 710, 711 aufgeklebt. Die Leiterplatte kann hierbei durchaus als Verbundleiterplatte mit mehreren unterschiedlichen Lagen ausgeführt sein (sog. Multilayer-Leiterplatte). Die Rollnaht- oder Laserschweißung zum Verschließen des Gehäuses entfällt bei diesem Aufbau.

Der Gehäusedeckel kann einstückig hergestellt sein oder aus mehreren Einzelteilen (Oberseite 701 und Seitenteile 702, 704, 703, 705) hergestellt sein. Der Deckel kann aus Kostengründen nicht als Frästeil, sondern aus Zinkdruckguss oder einem metallisierten Kunststoff hergestellt sein.

Weiterhin sind interne Trennstege 706 vorgesehen, die der Schirmung innerhalb des Gehäuses dienen. Diese Trennstege können bereits im Deckel integriert sein und somit auch metallisch ausgeführt sein. Eine andere Möglichkeit ist die Ausführung der internen Trennstege 706 aus Dämpfungsmaterial, wie auch das Dämpfungsmaterial im Deckenbereich 707. Auch können sowohl metallische als auch Trennstege aus Dämpfungsmaterial vorgesehen sein.

Für verschiedene Leiterplatten muss somit nur noch ein Gehäuserohling bereitgehalten werden. Die verschiedenen Versionen der Gehäuse für die verschiedenen Leiterplatten werden durch unterschiedliche Einlegeteile (Trennstege) oder unterschiedliches Einspritzen von Dämpfungsmaterial mit anschließendem Aushärten realisiert. Die elektrischen Verbindungen nach außen werden anstatt mit Glasdurchführungen mittels Durchkontaktierungen in der Leiterplatte ausgeführt, die wiederum an SMD-Stecker angeschlossen sind.

Auch in dem Ausführungsbeispiel der Fig. 7 ist die Unterseite der Leiterplatte 302 mit einer metallischen Schicht 708 versehen.

Die (flexiblen) Trennstege 706 können auf die Leiterplatte aufgepresst werden und sind nicht (wie im Ausführungsbeispiel der Fig. 6) durch die Leiterplatte durchgeführt.

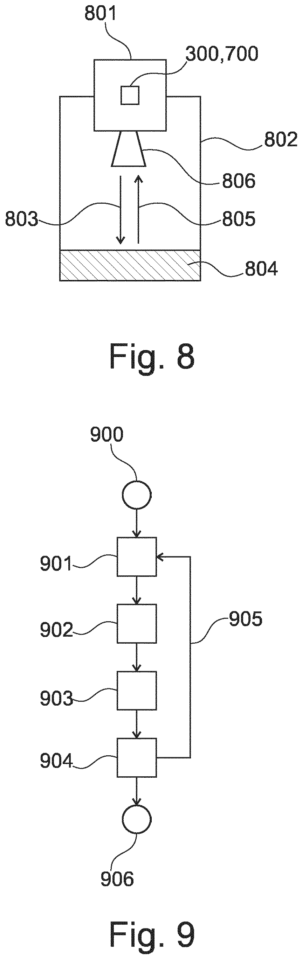

Fig. 8 zeigt ein Füllstandradar gemäß einem Ausführungsbeispiel der Erfindung. Das Füllstandradar 801 weist ein Hochfrequenzmodul 300, 700 auf. Das durch das Hochfrequenzmodul erzeugte Radarsignal 803 wird in Richtung Füllgutoberfläche 804 abgestrahlt und an der Füllgutoberfläche reflektiert. Das resultierende Reflexionssignal 805 wird von der Antenne 806 des Füllstandradars aufgenommen und anschließend ausgewertet. Das Füllstandradar ist beispielsweise in einen Behälter 802 eingebaut.

Fig. 9 zeigt ein Flussdiagramm eines Verfahrens, bei welchem in Schritt 900 eine Füllstandmessung gestartet wird. In Schritt 901 erfolgt das Anlegen einer negativen Versorgungsspannung an den Mikrowellenhalbleiter und in Schritt 902 wird dann eine positive Versorgungsspannung an den Mikrowellenhalbleiter angelegt. In Schritt 903 wird die positive Versorgungsspannung abgeschaltet und in Schritt 904 wird die negative Versorgungsspannung abgeschaltet. Daraufhin startet der Schritt 901 erneut (siehe Schritt 905). Auf diese Weise wird ein getakteter Betrieb der Spannungsversorgung des Mikrowellenhalbleiters realisiert. Nach den verschiedenen Messungen kann der Sensor ausgeschaltet werden (siehe Schritt 906).

Ergänzend ist darauf hinzuweisen, dass "umfassend" und "aufweisend" keine anderen Elemente oder Schritte ausschließt und "eine" oder "ein" keine Vielzahl ausschließt. Ferner sei daraufhingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

Weitere Ausführungsformen:
Ausführungsform 1: Hochfrequenzmodul zur Füllstandmessung bei Frequenzen von über 75 Gigaherz, das Hochfrequenzmodul aufweisend:
   zumindest einen Mikrowellenhalbleiter (301);
   eine Leiterplatte (302);
   ein Gehäuse (701, 702, 703, 704, 705) für das Hochfrequenzmodul, das auf die Leiterplatte (302) leitfähig aufgeklebt ist.
Ausführungsform 2: Hochfrequenzmodul nach Ausführungsform 1,
   wobei das Gehäuse (701, 702, 703, 704, 705) in einem Zinkdruckgussverfahren hergestellt ist.
Ausführungsform 3: Hochfrequenzmodul nach Ausführungsform 1,
   wobei das Gehäuse (701, 702, 703, 704, 705) in einem Kunststoffspritzgussverfahren hergestellt und metallisiert ist.
Ausführungsform 4: Hochfrequenzmodul nach einem der vorhergehenden Ausführungsformen,
   wobei das Gehäuse (701, 702, 703, 704, 705) einen integrierten Trennsteg (706) zur Schirmung von elektromagnetischer Strahlung aufweist, der ebenfalls metallisch ausgeführt ist.
Ausführungsform 5: Hochfrequenzmodul nach einem der vorhergehenden Ausführungsformen,
   wobei das Gehäuse (701, 702, 703, 704, 705) einen Trennsteg (706) zur Schirmung von elektromagnetischer Strahlung aufweist, der aus Dämpfungsmaterial besteht.
Ausführungsform 6: Hochfrequenzmodul nach einem der vorhergehenden Ausführungsformen,
   wobei das Hochfrequenzmodul zur Spannungsversorgung des Mikrowellenhalbleiters (301) in einem getakteten Betrieb ausgeführt ist.
Ausführungsform 7: Hochfrequenzmodul nach Ausführungsform 6,
   wobei bei dem getakteten Betrieb bei einem Anschaltvorgang zuerst eine negative Versorgungsspannung und dann eine positive Versorgungsspannung an den Mikrowellenhalbleiter (301) angelegt wird; und
   wobei bei einem Abschaltvorgang zuerst die positive Versorgungsspannung und dann die negative Versorgungsspannung abgeschaltet wird.
Ausführungsform 8: Hochfrequenzmodul nach Ausführungsform 6 oder 7,
   wobei der Mikrowellenhalbleiter (301) auf der Leiterplatte (302) platziert ist.
Ausführungsform 9: Hochfrequenzmodul nach einem der Ausführungsformen 6 bis 8,
   wobei der Mikrowellenhalbleiter (301) direkt auf die Leiterplatte (302) aufgeklebt ist.
Ausführungsform 10: Hochfrequenzmodul nach einem der Ausführungsformen 8 oder 9, weiterhin aufweisend:
   eine Metallisierung (303), die zwischen dem Mikrowellenhalbleiter (301) und der Leiterplatte (302) angeordnet ist.
Ausführungsform 11: Hochfrequenzmodul nach einem der vorhergehenden Ausführungsformen, weiterhin aufweisend:
   zumindest eine Signalleitung (304) auf der Leiterplatte (302), die mit dem Mikrowellenhalbleiter (301) verbunden ist.
Ausführungsform 12: Hochfrequenzmodul nach einem der vorhergehenden Ausführungsformen,
   wobei die Leiterplatte als Multilayerleiterplatte mit mehreren Lagen ausgeführt ist.
Ausführungsform 13: Hochfrequenzmodul nach einem der vorhergehenden Ausführungsformen,
   wobei das Hochfrequenzmodul zur Verwendung für einen Radarsensor zur Füllstandmessung ausgeführt ist.
Ausführungsform 14: Füllstandradar mit einem Hochfrequenzmodul nach einem der vorhergehenden Ausführungsformen.
Ausführungsform 15: Verfahren zum Betrieb eines Füllstandsensors mit einem Hochfrequenzmodul nach einem der Ausführungsformen 1 bis 13, das Verfahren aufweisend den Schritt:
   Versorgen des Mikrowellenhalbleiters (301) mit Spannung in einem getakteten Betrieb.
Ausführungsform 16: Verfahren nach Ausführungsform 15, weiterhin aufweisend die Schritte:
   Anlegen zuerst einer negativen Versorgungsspannung und dann einer positiven Versorgungsspannung an den Mikrowellenhalbleiter (301) zum Anschalten des Mikrowellenhalbleiters in einem Zyklus des getakteten Betriebs; und
   Abschalten zuerst der positiven Versorgungsspannung und dann der negativen Versorgungsspannung zum Abschalten des Mikrowellenhalbleiters in dem Zyklus des getakteten Betriebs.

## Patentansprüche

1. Hochfrequenzmodul zur Füllstandmessung bei Frequenzen von etwa 26 Gigaherz oder von über 75 Gigaherz, das Hochfrequenzmodul aufweisend:
zumindest einen Mikrowellenhalbleiter (301);
eine Leiterplatte (302);
ein Gehäuse (701, 702, 703, 704, 705) für das Hochfrequenzmodul, das an der Leiterplatte (302) angebracht ist:
wobei der Mikrowellenhalbleiter (301) in einer Aussparung (200) in der Leiterplatte (302) platziert ist.

2. Hochfrequenzmodul nach Anspruch 1,
wobei das Gehäuse (701, 702, 703, 704, 705) in einem Zinkdruckgussverfahren hergestellt ist.

3. Hochfrequenzmodul nach Anspruch 1,
wobei das Gehäuse (701, 702, 703, 704, 705) in einem Kunststoffspritzgussverfahren hergestellt und metallisiert ist.

4. Hochfrequenzmodul nach einem der vorhergehenden Ansprüche,
wobei das Gehäuse (701, 702, 703, 704, 705) einen integrierten Trennsteg (706) zur Schirmung von elektromagnetischer Strahlung aufweist, der ebenfalls metallisch ausgeführt ist.

5. Hochfrequenzmodul nach einem der vorhergehenden Ansprüche,
wobei das Gehäuse (701, 702, 703, 704, 705) einen Trennsteg (706) zur Schirmung von elektromagnetischer Strahlung aufweist, der aus Dämpfungsmaterial besteht.

6. Hochfrequenzmodul nach einem der vorhergehenden Ansprüche,
wobei das Gehäuse (701, 702, 703, 704, 705) auf die Leiterplatte (302) aufgeklebt oder an die Leiterplatte geklemmt ist.

7. Hochfrequenzmodul nach Anspruch 6,
wobei das Gehäuse (701, 702, 703, 704, 705) leitfähig auf die Leiterplatte (302) aufgeklebt oder an die Leiterplatte geklemmt ist.

8. Hochfrequenzmodul nach einem der vorhergehenden Ansprüche,
wobei das Hochfrequenzmodul zur Spannungsversorgung des Mikrowellenhalbleiters (301) in einem getakteten Betrieb ausgeführt ist.

9. Hochfrequenzmodul nach Anspruch 8,
wobei bei dem getakteten Betrieb bei einem Anschaltvorgang zuerst eine negative Versorgungsspannung und dann eine positive Versorgungsspannung an den Mikrowellenhalbleiter (301) angelegt wird; und
wobei bei einem Abschaltvorgang zuerst die positive Versorgungsspannung und dann die negative Versorgungsspannung abgeschaltet wird.

10. Hochfrequenzmodul nach einem der vorhergehenden Ansprüche, weiterhin aufweisend:
eine Metallisierung (201) auf der Unterseite der Leiterplatte.

11. Hochfrequenzmodul nach Anspruch 10, weiterhin aufweisend:
eine Metall-Lage (202) zur Wärmeableitung, auf der die Leiterplatte (302) mit ihrer Metallisierung (201) aufgesetzt ist.

12. Hochfrequenzmodul nach Anspruch 11,
wobei der Mikrowellenhalbleiter (301) direkt auf die Metall-Lage (202) aufgeklebt ist, um eine elektrische Masseverbindung auf die Unterseite des Mikrowellenhalbleiters und eine Wärmeableitung zu gewährleisten.

13. Hochfrequenzmodul nach einem der vorhergehenden Ansprüche,
wobei das Hochfrequenzmodul zur Verwendung für einen Radarsensor zur Füllstandmessung ausgeführt ist.

14. Füllstandradar mit einem Hochfrequenzmodul nach einem der vorhergehenden Ansprüche.

15. Verfahren zum Betrieb eines Füllstandsensors mit einem Hochfrequenzmodul nach einem der Ansprüche 1 bis 13, das Verfahren aufweisend den Schritt:
Versorgen des Mikrowellenhalbleiters (301) mit Spannung in einem getakteten Betrieb.

16. Verfahren nach Anspruch 15, weiterhin aufweisend die Schritte:
Anlegen zuerst einer negativen Versorgungsspannung und dann einer positiven Versorgungsspannung an den Mikrowellenhalbleiter (301) zum Anschalten des Mikrowellenhalbleiters in einem Zyklus des getakteten Betriebs; und
Abschalten zuerst der positiven Versorgungsspannung und dann der negativen Versorgungsspannung zum Abschalten des Mikrowellenhalbleiters in dem Zyklus des getakteten Betriebs.
